(19) 
**Europäisches Patentamt**

**European Patent Office**

**Office européen des brevets**

(11) Numéro de publication: **0 194 195**
**B1**

(12) **FASCICULE DE BREVET EUROPEEN**

(45) Date de publication du fascicule du brevet:
12.12.90

(51) Int. Cl.⁵: **H03K 3/356**

(21) Numéro de dépôt: 86400404.9

(22) Date de dépôt: 25.02.86

(54) Bascule bistable statique en technologie CMOS.

(30) Priorité: 28.02.85 FR 8502972

(43) Date de publication de la demande:
10.09.86 Bulletin 86/37

(45) Mention de la délivrance du brevet:
12.12.90 Bulletin 90/50

(84) Etats contractants désignés:
AT DE FR GB IT NL

(56) Documents cités:
WO-A-84/03806
GB-A- 1 113 111
GB-A- 2 131 993
US-A- 4 253 162
US-A- 4 390 987

PATENTS ABSTRACTS OF JAPAN, vol. 4, no. 28 (E-1)
[510], 8 mars 1980, page 141 E 1; & JP - A
- 55 3234 (TOKYO SHIBAURA DENKI K.K.) 11-01-1980
SIEMENS FORSCHUNGS- UND
ENTWICKLUNGSBERICHTE,
vol. 5, no. 6, 1976, pages 344-349, Springer-Verlag,
Berlin, DE; E. GONAUSER et al.: "A master slice design
concept based on master cells in ESFI-SOS-CMOS
technology"

(73) Titulaire: SGS-THOMSON MICROELECTRONICS S.A., 7,
Avenue Galliéni, F-94250 Gentilly(FR)

(72) Inventeur: Zangara, Louis, THOMSON-CSF
SCPI 19, avenue de Messine, F-75008 Paris(FR)

(74) Mandataire: Rinuy, Santarelli, 14, avenue de la Grande
Armée, F-75017 Paris(FR)

## Description

L'invention concerne les circuits intégrés réalisés en technologie CMOS, c'est-à-dire utilisant simultanément sur un même substrat semiconducteur des transistors à effet de champ à canal N et des transistors à effet de champ à canal P.

De nombreux circuits logiques nécessitent l'utilisation de bascules bistables statiques (bascules D à verrouillage).

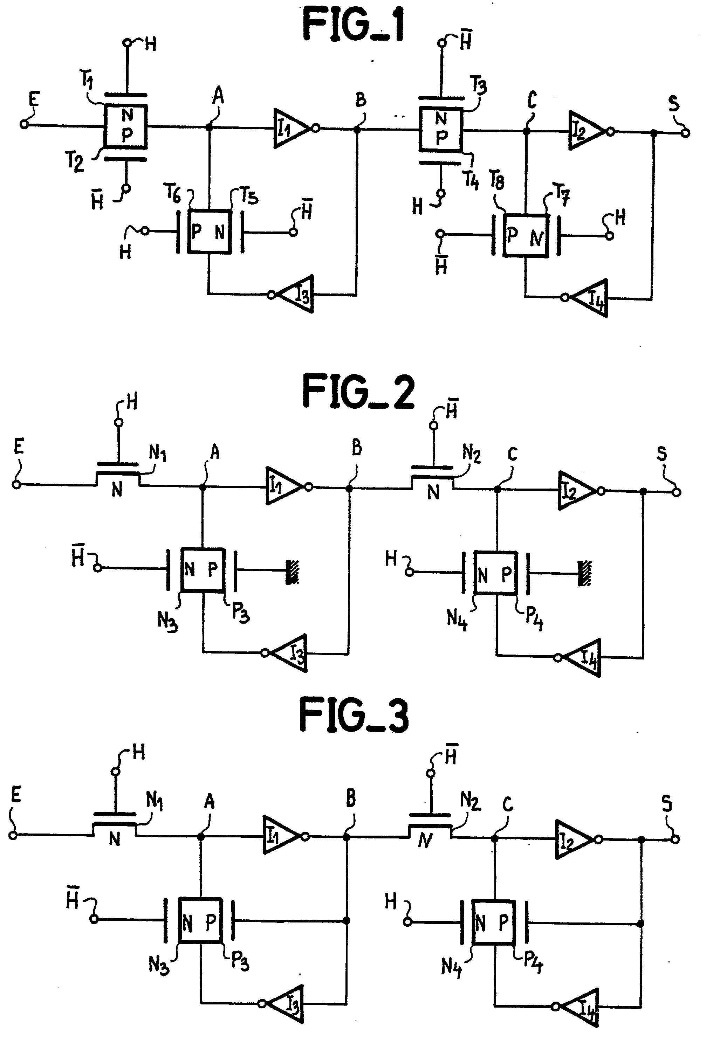

Un schéma de bascule bistable statique classique, réalisé en technologie CMOS, est représenté à la figure 1.

Cette bascule comporte une entrée E, une sortie S, et entre les deux, un ensemble en cascade comprenant un premier interrupteur, un premier étage inverseur, un deuxième interrupteur et un deuxième étage inverseur. La bascule est commandée par deux signaux d'horloge périodiques complémentaires H et H̄

Le premier interrupteur comprend un transistor MOS T1 à canal N en parallèle avec un transistor MOS T2 à canal P, ces deux transistors étant placés entre la borne d'entrée E et l'entrée A d'un inverseur I1 du premier étage inverseur. La grille du transistor T1 à canal N est commandée par le signal d'horloge H, la grille du transistor T2 à canal P est commandée par le signal d'horloge complémentaire H̄.

Le deuxième interrupteur comprend un transistor MOS T3 à canal N en parallèle avec un transistor MOS T4 à canal P ; ces deux transistors sont placés entre la sortie B de l'inverseur I1 et l'entrée C d'un inverseur I2 du deuxième étage inverseur. La grille du transistor à canal N T3 est commandée par le signal d'horloge complémentaire H̄ ; la grille du transistor à canal P T4 est commandée par le signal d'horloge H.

Le premier étage inverseur comprend, entre les noeuds de circuit A et B, outre l'inverseur I1 qui a son entrée reliée au noeud A et sa sortie au noeud B, une boucle de maintien comprenant un troisième inverseur I3 et un troisième interrupteur. Le troisième inverseur a son entrée reliée au noeud B et sa sortie reliée au noeud A par l'intermédiaire du troisième interrupteur. Le troisième interrupteur comprend un transistor MOS T5 à canal N en parallèle avec un transistor MOS T6 à canal P. La grille du transistor à canal N T5 est commandée par le signal d'horloge complémentaire H̄ ; la grille du transistor MOS à canal P T6 est commandée par le signal d'horloge H.

De la même façon, le deuxième étage inverseur comprend, entre le noeud C et la sortie S de la bascule, d'une part l'inverseur I2 qui a son entrée reliée au noeud C et sa sortie reliée à la sortie S, et d'autre part une boucle de maintien comprenant un quatrième inverseur I4 et un quatrième interrupteur. Le quatrième inverseur a son entrée reliée à la borne S et sa sortie reliée au quatrième interrupteur; le quatrième interrupteur est par ailleurs relié au noeud C et il comprend en parallèle un transistor T7 à canal N et un transistor T8 à canal P. La grille du transistor T7 à canal N est commandée par le signal d'horloge H. La grille du transistor T8 à canal P est commandée par le signal d'horloge complémentaire H̄.

Les inverseurs sont en principe chacun constitués de deux transistors complémentaires en série entre deux bornes d'alimentation en énergie non représentées fournissant une tension d'alimentation VCC. L'entrée de l'inverseur est prise sur les grilles reliées des deux transistors, la sortie sur leurs drains.

Le fonctionnement de la bascule est le suivant :

a) première demi-période : H au niveau logique 1; T1 et T2 sont conducteurs, T3 et T4 bloqués, T5 et T6 bloqués. Le niveau logique de l'entrée E est inversé à la sortie B de l'inverseur I1. Le deuxième étage inverseur n'est pas influencé par l'entrée E puisque les transistors T3 et T4 sont bloqués.

b) deuxième demi-période : H̄ au niveau logique 1; T1 et T2 sont bloqués ; l'entrée E n'a plus d'influence sur l'état de la bascule ; T5 et T6 sont rendus conducteurs et l'état précédent du noeud B est confirmé par l'application du complément de cet état sur le noeud A à travers l'inverseur I3 et les transistors T5, T6. Cet état du noeud B, confirmé par cette boucle de verrouillage, est par ailleurs transmis à l'entrée C du deuxième inverseur I2 et la sortie S prend donc l'état complémentaire de celui du noeud B.

c) première demi-période de la période suivante; H est au niveau logique 1. L'état de la sortie S est confirmé par la boucle de verrouillage du deuxième étage puisque T7 et T8 deviennent conducteurs en même temps que T3 et T4 se bloquent.

Ce montage classique de bascule présente un certain nombre d'inconvénients que la présente invention élimine dans une large mesure.

1°/ Le fonctionnement décrit ci-dessus n'est efficace que si les signaux H et H̄ sont rigoureusement complémentaires ; car s'il y a un recouvrement partiel des signaux H et H̄, on risque d'avoir une transmission directe des signaux d'entrée vers la sortie sans verrouillage par l'un des groupes de transistors T1, T2 ou T3, T4 : par exemple si H et H̄ présentent un intervalle de temps de recouvrement pendant lequel H et H̄ sont pratiquement tous deux au niveau 1, T1 et T3 sont simultanément conducteurs, ce qui n'est pas admissible ; cela arrive également si les signaux H et H̄ ont des fronts de montée insuffisamment raides.

Lorsque la fréquence de fonctionnement augmente, il devient extrêmement difficile de faire des signaux complémentaires H et H̄ sans recouvrement (c'est-à-dire des signaux parfaitement complémentaires et à fronts de montée et descente très raides).

2°/ De toutes façons, il est difficile d'avoir des signaux à fronts de montée très raides lorsque ces signaux sont appliqués à une charge capacitive ; or les grilles des divers transistors commandés par les horloges H et H̄ sont bien des charges capacitives ; plus les transistors sont nombreux plus il sera difficile de conserver des fronts raides pour les signaux d'horloge. Il ne faut pas oublier qu'en pratique un circuit intégré pourra comporter de nombreuse bascules commandées par les mêmes signaux

d'horloge. On a donc intérêt à réduire le nombre de transistors utilisés.

3°/ Un problème qu'il faut prendre en compte dans la réalisation d'une bascule, ou plus généralement d'un inverseur (et la bascule de la figure 1 comporte quatre inverseurs), est le niveau de tension d'entrée à partir duquel l'inverseur bascule (dans un sens ou dans l'autre) : il faut que l'inverseur bascule franchement pour une valeur de tension d'entrée intermédiaire entre la tension qui définit le niveau logique bas et celle qui définit le niveau logique haut.

Par exemple, pour une logique fonctionnant entre 0 et 5 volts théoriquement, on peut s'arranger pour que le basculement se produise à 2,5 volts. Comme la mobilité des charges électriques dans les transistors à canal P est plus faible que dans les transistors à canal N, on prévoit en général pour résoudre ce problème que les transistors à canal P des inverseurs sont deux fois plus gros que les transistors à canal N. Mais cela augmente l'encombrement global de la bascule et c'est un inconvénient.

Pour éviter ces inconvénients la présente invention part de l'idée qu'on peut se dispenser d'utiliser pour certains interrupteurs deux transistors complémentaires en parallèle. Pour bien comprendre l'aspect inattendu de cette proposition, il faut se rappeler que dans la technologie CMOS on s'arrange, chaque fois que c'est possible, pour utiliser comme interrupteur un ensemble de deux transistors MOS complémentaires actionnés par deux signaux d'horloge complémentaires ; ceci est vrai en particulier chaque fois qu'un interrupteur doit être placé en amont d'un inverseur.

La raison de cette disposition quasi-universelle est la suivante : si l'interrupteur n'était constitué que d'un transistor à canal N, il n'y aurait pas de problème pour transmettre un niveau logique bas (0 volt) à travers l'interrupteur vers l'entrée de l'inverseur : s'il y a 0 volt à l'entrée du transistor à canal N pendant que celui-ci est rendu conducteur, il y a aussi 0 volt sur sa sortie. Mais, pour transmettre un niveau haut (5 volts) ce n'est plus le cas ; en effet, s'il y a 5 volts à l'entrée du transistor à canal N pendant qu'il est rendu conducteur, il y a seulement 5 volts-Vt à sa sortie, Vt étant la tension de seuil du transistor. Or l'inverseur, en technologie CMOS, est constitué par un transistor à canal P en série avec un transistor à canal N, les grilles des deux transistors étant réunies pour constituer l'entrée de l'inverseur ; appliquer 5 volts-Vt à l'entrée de l'inverseur est alors certes suffisant pour rendre conducteur le transistor à canal N mais c'est insuffisant pour bloquer convenablement le transistor à canal P. L'inverseur ne fonctionne pas bien ; il consomme du courant. C'est pourquoi on prévoit toujours en amont d'un inverseur CMOS, depuis qu'on s'est rendu compte de ce problème, des interrupteurs à deux transistors complémentaires en parallèle, les deux transistors étant actionnés par des signaux d'horloge complémentaires lorsque le deuxième transistor de l'interrupteur doit transmettre un niveau haut (5 volts) il transmet bien ce niveau haut sans le faire chuter d'une tension de seuil.

Selon l'invention telle que revendiquée, on prévoit une bascule bistable statique en technologie CMOS comprenant une entrée, une sortie, un premier inverseur, un premier interrupteur reliant l'entrée de la bascule à l'entrée du premier inverseur, un deuxième inverseur, un deuxième interrupteur reliant la sortie du premier inverseur à l'entrée du deuxième inverseur, un troisième inverseur, un troisième interrupteur reliant la sortie du troisième inverseur à l'entrée du premier inverseur, un quatrième inverseur, un quatrième interrupteur reliant la sortie du quatrième inverseur à l'entrée du deuxième inverseur, le premier interrupteur et le quatrième interrupteur étant commandés en phase par un premier signal d'horloge et le second et le troisième interrupteurs étant commandés en phase par un deuxième signal d'horloge en opposition de phase avec le premier, caractérisé en ce que

- chaque interrupteur est constitué par un unique transistor à effet de champ à canal N, dont la grille est commandée par le premier signal d'horloge (premier et quatrième interrupteurs) et par le deuxième signal d'horloge (deuxième et troisième interrupteurs)

- deux transistors MOS à canal P sont prévus, le premier transistor à canal P étant placé en parallèle sur le troisième interrupteur et ayant sa grille connectée à un premier noeud de circuit tel qu'il soit conducteur au moins lorsque la sortie du premier inverseur est à un niveau logique bas, et le second transistor à canal P étant placé en parallèle sur le quatrième interrupteur et ayant sa grille connectée à un deuxième noeud de circuit tel qu'il soit conducteur au moins lorsque la sortie du deuxième inverseur est à un niveau logique bas.

Le premier noeud de circuit peut être la sortie du premier inverseur ou un point à un potentiel de référence constituant un niveau logique bas, par exemple la masse.

Le deuxième noeud de circuit peut être la sortie du deuxième inverseur ou un point à un potentiel de référence constituant un niveau logique bas, par exemple la masse.

D'autres caractéristiques et avantages de l'invention apparaîtront à la lecture de la description détaillée qui suit et qui est faite en référence aux dessins annexés dans lesquels :

- la figure 1 déjà décrite représente une bascule classique de la technique antérieure,

- la figure 2 représente un premier mode de réalisation de la bascule selon l'invention.

- la figure 3 représente un deuxième mode de réalisation de la bascule selon l'invention.

Le schéma de la bascule à verrouillage de la figure 2 est similaire dans son architecture à celui de la figure 1, mais il montre clairement que maintenant :

- les interrupteurs sont chacun constitué par un unique transistor à canal N commandé soit par le signal d'horloge H soit par le signal d'horloge complémen- taire H̄ : le transistor N1 (premier interrupteur placé entre l'entrée E de la bascule et l'entrée A du pre- mier inverseur I1) est commandé par le signal H ; le transistor N2 isolant le premier inverseur I1 du se-

cond inverseur I2 est commandé par le signal $\overline{H}$ ; le transistor N3 reliant la sortie du troisième inverseur I3 à l'entrée du premier inverseur I1 est commandé par le signal $\overline{H}$ ; enfin le transistor N4, reliant la sortie du quatrième inverseur I4 à l'entrée du deuxième inverseur I2 est commandé par le signal H.

- de plus, deux transistors à canal P, P3 et P4, de dimensions non critiques (par exemple de même largeur de canal que les transistors N3 et N4), sont placés l'un en parallèle sur le transistor N3, l'autre en parallèle sur le transistor N4 ; les grilles de ces transistors sont reliées à la masse ou à tout potentiel susceptible de les rendre franchement conducteurs.

Le fonctionnement de ce circuit est à la base le même que celui de la figure 1, mais avec une différence fondamentale qui marque bien le caractère inattendu du schéma selon l'invention : alors que dans la bascule de la figure 1 rien ne s'oppose au basculement du premier inverseur pandant la phase d'horloge H, ni au basculement du deuxième inverseur pendant la phase d'horloge $\overline{H}$, il y a maintenant un conflit entre le signal direct imposé par l'entrée et le signal imposé par les boucles de verrouillage.

Par exemple, si l'état verrouillé par l'inverseur I3 est un niveau logique haut sur le noeud A, et si on veut forcer un état bas par l'entrée E pendant la phase H, il y a un conflit momentané à travers les transistors P3 et N1 qui sont conducteurs et tendent à imposer des états contradictoires sur le noeud A.

Dans ces conditions, le noeud A prendra initialement un potentiel qui dépend des rapports entre les conductances des transistors situés de part et d'autre du noeud A. On s'arrange pour que les conductances soient telles que le noeud A prenne un potentiel suffisamment haut pour faire basculer l'inverseur I1. Aussitôt le conflit cesse puisque l'inverseur I3 bascule aussi et applique maintenant le même niveau logique que l'entrée E. Seule une courte phase transitoire est donc critique mais elle se résoud par le dimensionnement approprié des transistors. En pratique on pourra donner aux transistors les dimensions suivantes (par exemple), exprimées par le rapport W/L entre la largeur de grille W et la longueur de canal L des transistors :

- transistors des inverseurs, y compris ceux qui seraient en amont de l'entrée E de la bascule : $W/L = 3/2$
- transistor N1, N2 : $W/L = 5/2$ (transistor large),
- transistors P3, P4 : $W/L = 3/5$ (transistors longs).

Si maintenant on examine ce qui se passe lorsque l'état verrouillé sur le noeud A est un état haut et qu'on veut forcer un état bas par l'entrée E, on vérifie que la situation est la même : un conflit transitoire existe et disparait très rapidement si le dimensionnement des transistors est convenablement choisi. En fait on peut vérifier que ce conflit est beaucoup moins critique que le précédent (dans le cas où les inverseurs comportent des transistors N et P de même dimension), ceci à cause de la conductivité naturellement plus faible des transistors à canal P. Les dimensions de transistors choisies à titre d'exemple ci-dessus pour permettre le basculement dans le sens état bas vers état haut (au noeud A) sont encore plus favorables au basculement dans le sens inverse.

La situation ainsi décrite à propos du noeud A est exactement la même au noeud C.

La figure 3 représente un autre mode de réalisation de l'invention. La grille du transistor P3 n'est plus à la masse mais reliée à la sortie de l'inverseur I1. De même la grille du transistor P4 est reliée à la sortie de l'inverseur I2.

Lorsqu'un état logique haut est verrouillé sur le noeud A, la situation est exactement la même que dans le cas de la figure 2 ; le transistor P3 est conducteur. Il y a un conflit momentané si on veut forcer le noeud A à un état bas par l'entrée E pendant le signal d'horloge H. Ce conflit est d'ailleurs celui qui est le plus facile à résoudre comme on l'a dit ci-dessus (plus facile que le conflit consistant à forcer un état haut lorsqu'un état bas est verrouillé).

Lorsqu'un état logique bas est verrouillé sur le noeud A, il n'y a cette fois aucun problème de conflit car la grille du transistor P3 est à un niveau logique haute qui le bloque ; la sortie de l'inverseur I3 est alors isolée du noeud A par les transistors N3 et P3 tous deux bloqués.

La disposition de la figure 3 améliore donc considérablement le problème des conflits de basculement, au prix d'une charge capacitive supplémentaire pour les inverseurs I1 et I2 qui doivent maintenant commander les transistors P3 et P4.

Dans le cas de la figure 3, on peut prévoir les mêmes rapports W/L que ceux qui ont été indiqués par la figure 2. Toutefois les transistors P3 et P4 peuvent être plus court, par exemple identiques aux transistors des inverseurs ($W/L = 3/2$) puisque le problème de conflit à résoudre n'existe que pour le sens de conflit le plus facile à résoudre.

On peut imaginer bien entendu que les schémas des figures 2 et 3 soient mélangés, c'est-à-dire qu'un étage soit construit avec le transistor à canal P commandé par la masse et l'autre étage avec le transistor à canal P commandé par la sortie de l'inverseur I1 ou I2.

Grâce à ces schémas selon l'invention, on obtient les avantages suivants :

1) le nombre de transistors du circuit, outre les transistors constituant les inverseurs, n'est que de six (au lieu de huit), réduisant l'encombrement de la bascule ;

2) le nombre de transistors commandés par les signaux d'horloge n'est que de quatre (au lieu de huit), réduisant la charge capacitive des lignes transportant les signaux d'horloge ;

3) il n'y a plus besoin de prévoir des signaux d'horloge aussi parfaitement complémentaires et à fronts extrêmement raides comme cela était nécessaire. Il suffit en effet que le niveau haut de $\overline{H}$ soit bien disjoint du niveau haut de H (pas de recouvrement des niveaux hauts). Mais les niveaux bas peuvent avoir un léger recouvrement sans inconvénient puisqu'il n'y a plus de transistors à canal P dans la chaine directe entre l'entrée E et la sortie S. La rapidité de fonctionnement peut donc être augmentée ;

4) les transistors constituant les inverseurs peuvent avoir une même largeur de canal (au lieu d'une largeur double le plus souvent prévue pour les transistors à canal P), réduisant encore l'encombrement de la bascule ;

5) lorsqu'un niveau logique haut est appliqué sur l'entrée E, le noeud A passe au niveau haut, éventuellement après un conflit momentané ; le transistor P3 est alors conducteur ou le devient (figure 3) et le potentiel ramené sur le noeud A à travers un transistor à canal P conducteur est un vrai niveau logique haut et pas un niveau haut diminué d'une tension de seuil de transistor.

## Revendications

1. Bascule bistable statique en technologie CMOS comprenant une entrée (E), une sortie (S), un premier inverseur (I1), un premier interrupteur (N1) reliant l'entrée de la bascule à l'entrée du premier inverseur, un deuxième inverseur (I2) dont la sortie correspond à la sortie (S) de la bascule, un deuxième interrupteur (N2) reliant la sortie du premier inverseur à l'entrée du deuxième inverseur, un troisième inverseur (I3) dont l'entrée est reliée à la sortie du premier inverseur, un troisième interrupteur (N3) reliant la sortie du troisième inverseur à l'entrée du premier inverseur, un quatrième inverseur (I4) dont l'entrée est reliée à la sortie du deuxième inverseur, un quatrième interrupteur (N4) reliant la sortie du quatrième inverseur à l'entrée du deuxième inverseur, les premier et quatrième interrupteurs étant commandés en phase par un deuxième signal d'horloge en opposition de phase avec le premier, caractérisé en ce que:

– chaque interrupteur est constitué par un unique transistor à effet de champ à canal N, dont la grille est commandée par le premier signal d'horloge en ce qui concerne les premier et quatrième interrupteurs et par le deuxième signal d'horloge en ce qui concerne les deuxième et troisième interrupteurs,

– deux transistors MOS à canal P sont prévus, le premier transistor à canal P (P3) étant placé en parallèle sur le troisième interrupteur et ayant sa grille connectée à un nœud de circuit tel qu'il soit conducteur au moins lorsque la sortie du premier inverseur est à un niveau logique bas, et le second transistor à canal P (P4) étant placé en parallèle sur le quatrième interrupteur et ayant sa grille connectée à un deuxième nœud de circuit tel qu'il soit conducteur au moins lorsque la sortie du deuxième inverseur est à un niveau logique bas,

– la conductance des transistors des premier et deuxième interrupteurs (N1, N2) est supérieure à celle des transistors constituant les inverseurs qui est elle-même supérieure ou égale à celle des transistors MOS à canal P.

2. Bascule bistable selon la revendication 1, caractérisée en ce que le premier nœud de circuit et le second nœud de circuit sont constitués par une masse à un niveau logique bas.

3. Bascule bistable selon la revendication 2, caractérisée en ce que les transistors à canaux P en parallèle sur les troisième et quatrième interrupteurs sont des transistors à canaux plus longs que les autres transistors de la bascule.

4. Bascule bistable selon la revendication 1, caractérisée en ce que le premier noeud de circuit est la sortie du premier inverseur et le deuxième noeud est la sortie du deuxième inverseur.

5. Bascule bistable statique en technologie CMOS selon la revendication 1, dans lequel les inverseurs comportent chacun deux transistors complémentaires en série entre des bornes d'alimentation, les grilles des transistors étant reliées pour constituer l'entrée de l'inverseur, caractérisée en ce que la largeur de canal est sensiblement la même pour ces deux transistors complémentaires de l'inverseur.

## Claims

1. A static bistable flip-flop produced by CMOS technology, comprising an input (E), an output (S), a first inverter (I1), a first switch (N1) connecting the input of the flip-flop to the input of the first inverter, a second inverter (I2), the output of which corresponds to the output (S) of the flip-flop, a second switch (N2) connecting the output of the first inverter to the input of the second inverter, a third inverter (I3), the input of which is connected to the output of the first inverter, a third switch (N3) connecting the output of the third inverter to the input of the first inverter, a fourth inverter (I4), the input of which is connected to the output of the second inverter, a fourth switch (N4) connecting the output of the second inverter to the input of the second inverter; the first and fourth switches being simultaneously controlled by a second clock signal in phase opposition with the first, characterized in this that:

– each switch is constituted by a single field effect N-channel transistor, the gate of which is controlled by said first clock signal as regards the first and fourth switches, and the gate of which is controlled by the second clock signal as regards the second and third switches;

– two P-channel MOS transistors are included, the first P-channel transistor (P3) being placed in parallel on the third switch and having its gate connected to a circuit node so that it is conductive at least when the output of the first inverter is at a low logic level, and the second P-channel transistor (P4) being placed in parallel on the fourth switch and having its gate connected to a second circuit node so that it is conductive at least when the output of the second inverter is at a low logic level,

– the conductance of the transistors of the first and second switches (N1, N2) is larger than that of the transistors constituting the inverters, the latter being equal or higher than that of the P-channel MOS transistors.

2. A bistable flip-flop according to claim 1, characterized in this that the first node of the circuit and the second node of the circuit are constituted by the ground at a low logic level.

3. A bistable flip-flop according to claim 2, characterized in this that the P-channel transistors in parallel on the third and fourth switches have a channel length greater than the other transistors of the flip-flop.

4. A bistable flip-flop according to claim 1, characterized in this that the first node of the circuit is the output of the first switch and the second node is the output of the second inverter.

5. A bistable static fllip-flop produced through CMOS technology according to claim 1, in which each of the inverters comprises two complementary transistors in series between input terminals, the gates of the transistors being connected in order to constitute the input of the inverter, characterized in this that the channel width is substantially the same for said two complementary transistors of the inverter.

## Patentansprüche

1. Statische bistabile Kippschaltung in CMOS-Technologie, mit einem Eingang (E), einem Ausgang (S), einem ersten Inverter (I1), einem ersten Schalter (N1), der den Eingang der Kippschaltung mit dem Eingang des ersten Inverters verbindet, mit einem zweiten Inverter (I2), dessen Ausgang den Ausgang (S) der Kippschaltung bildet, mit einem zweiten Schalter (N2), der den Ausgang des ersten Inverters mit dem Eingang des zweiten Inverters verbindet, mit einem dritten Inverter (I3), dessen Eingang mit dem Ausgang des ersten Inverters verbunden ist, mit einem dritten Schalter (N3), der den Ausgang des dritten Inverters mit dem Eingang des ersten Inverters verbindet, mit einem vierten Inverter (I4), dessen Eingang mit dem Ausgang des zweiten Inverters verbunden ist und mit einem vierten Schalter (N4), der den Ausgang des vierten Inverters mit dem Eingang des zweiten Inverters verbindet, wobei der erste und vierte Schalter gleichphasig durch ein erstes Taktsignal und der zweite und dritte Schalter gleichphasig durch ein zweites Taktsignal angesteuert werden, welches zum ersten Taktsignal in Gegenphase liegt, dadurch gekennzeichnet,

- daß jeder Schalter durch einen einzigen N-Kanal-Feldeffekttransistor gebildet ist, dessen Steuerelektrode, sofern der erste und vierte Schalter betroffen ist, durch das erste Taktsignal bzw., sofern der zweite und dritte Schalter betroffen ist, durch das zweite Taktsignal angesteuert wird,

- daß zwei MOS-Transistoren mit P-Kanal vorgesehen sind, wobei der erste P-Kanal-Transistor (P3) parallel zum dritten Schalter gelegen und mit seiner Steuerelektrode mit einem ersten Schaltungspunkt verbunden ist, so daß er zumindest dann leitend ist, wenn der Ausgang des ersten Schalters auf einem niedrigen logischen Niveau ist, und wobei der zweite P-Kanal-Transistor (P4) parallel zum vierten Schalter gelegen und mit seiner Steuerelektrode mit einem zweiten Schaltungspunkt verbunden ist, so daß er zumindest dann leitend ist, wenn der Ausgang des zweiten Inverters auf einem niedrigen logischen Niveau ist, und

- daß die Leitfähigkeit der Transistoren des ersten und zweiten Schalters (N1, N2) höher als diejenige der die Inverter bildenden Transistoren ist, wobei letztere höher als die der P-Kanal-MOS-Transistoren oder gleich dieser ist.

2. Bistabile Kippschaltung nach Anspruch 1, dadurch gekennzeichnet, daß der erste und zweite Schaltungspunkt jeweils durch einen Massenpunkt mit einem niedrigen logischen Niveau gebildet ist.

3. Bistabile Kippschaltung nach Anspruch 2, dadurch gekennzeichnet, daß die parallel zu dem dritten bzw. vierten Schalter gelegenen P-Kanal-Transistoren eine Kanallänge aufweisen, die größer als bei den anderen Transistoren der Kippschaltung ist.

4. Bistabile Kippschaltung nach Anspruch 1, dadurch gekennzeichnet, daß der erste Schaltungspunkt der Ausgang des ersten Inverters und der zweite Schaltungspunkt der Ausgang des zweiten Inverters ist.

5. Bistabile Kippschaltung in CMOS-Technologie nach Anspruch 1, bei der die Inverter jeweils zwei komplementäre Transistoren in Serie zwischen Zuleitungsanschlüssen aufweisen und die Steuerelektroden der Transistoren verbunden sind, um dort den Eingang des Inverters zu bilden, dadurch gekennzeichnet, daß die Kanallänge der beiden komplementären Transistoren des Inverters gleich ist.

EP 0 194 195 B1

FIG_1

FIG_2

FIG_3